# DEMANDE DE BREVET EUROPEEN

(11) **EP 4 002 367 A1**
(43) Date de publication de la demande: **25.05.2022**
(21) Numéro de dépôt: 21205445.6
(22) Date de dépôt: 29.10.2021
(51) Int. Cl.: G11C 7/10, G06F 13/42, G06F 13/16

(54) **PROCÉDÉ DE GESTION D'UNE OPÉRATION DE MODIFICATION DU CONTENU MÉMORISÉ D'UN DISPOSITIF DE MÉMOIRE, ET DISPOSITIF DE MÉMOIRE CORRESPONDANT**

(30) Priorité: 12.11.2020 FR 2011586
(71) Demandeur: STMicroelectronics (Rousset) SAS, 13790 Rousset (FR)
(72) Inventeur: DIONIS, Gilles, 13790 Peynier (FR)
(74) Mandataire: Casalonga

(57) **Abrégé**

Procédé de gestion d'une opération de modification du contenu du plan mémoire d'un dispositif de mémoire couplé à une unité de traitement, comprenant une communication (ST20) par l'unité de traitement (UT) au dispositif de mémoire (DM) d'une commande de ladite opération, une exécution (ST21) de ladite opération par le dispositif de mémoire, et à l'issue de ladite opération, une communication (ST22) par le dispositif mémoire lui-même à ladite unité de traitement d'une information (INFF) indiquant la fin de ladite opération.

## Description

L'invention concerne la microélectronique, notamment les dispositifs de mémoire et plus particulièrement la gestion de la modification du contenu de leur plan-mémoire, par exemple lors d'une opération d'écriture.

L'invention s'applique à tous types de mémoires, en particulier mais non limitativement, les mémoires non volatiles du type électriquement effaçable et programmable (mémoires EEPROM) ou encore les mémoires flash.

Une modification du contenu du plan-mémoire englobe d'une façon générale une opération d'écriture dans ce plan-mémoire, mais également selon le vocabulaire utilisé pour différents types de mémoires, un cycle d'écriture (étape d'effacement suivie d'une étape de programmation) d'une mémoire EEPROM ou encore une programmation (cycle écriture-effacement) d'une mémoire flash.

Actuellement, quand un dispositif de mémoire est utilisé dans une application dans laquelle elle est connectée à une unité de traitement, par exemple un microprocesseur ou un microcontrôleur, la seule façon de savoir si la mémoire est à nouveau disponible après la commande d'une opération de modification du contenu de son plan-mémoire (écriture, effacement ou programmation) est d'utiliser les ressources du microprocesseur pour vérifier l'état de la mémoire.

Plus précisément, selon une première solution, le microprocesseur peut déclencher en interne un compteur temporel lors de l'émission de la commande d'écriture. La valeur de ce compteur dépend des caractéristiques de la mémoire. Lorsque le compteur a atteint sa valeur maximale de comptage, l'opération d'écriture est alors réputée effectuée.

Selon une deuxième solution, le microprocesseur peut effectuer une opération dite de « polling » selon une dénomination anglosaxonne bien connue de l'homme du métier, consistant à interroger la mémoire pour connaître l'état logique de certains bits de contrôle de façon à déterminer à quel moment l'opération d'écriture a pris fin et par conséquent la mémoire est à nouveau disponible.

Cependant, quelle que soit la solution envisagée, celle-ci nécessite pour le microprocesseur l'utilisation de ressources internes qui ne peuvent pas alors être disponibles pour effectuer d'autres actions. En outre, l'utilisation de ces ressources internes peut ralentir l'application et augmenter la consommation de courant.

En outre, en ce qui concerne la première solution mentionnée ci-avant, la valeur maximale de comptage est généralement prise par défaut plus grande que le temps nécessaire pour effectuer l'opération d'écriture.

Il existe par conséquent un besoin de remédier aux inconvénients mentionnés ci-avant et de proposer une solution permettant à une unité de traitement, par exemple un microprocesseur, de déterminer l'instant de fin d'une opération de modification du contenu du plan-mémoire d'un dispositif de mémoire sans trop impacter son fonctionnement en termes notamment de consommation.

Il est également proposé d'apporter une solution qui n'impacte pas l'encombrement surfacique du microprocesseur et du dispositif de mémoire.

Selon un mode de mise en œuvre et de réalisation, il est proposé que ce soit le dispositif de mémoire lui-même qui informe l'unité de traitement de la fin d'une opération de modification de son contenu mémoire, par exemple une opération d'écriture, en utilisant en particulier une broche du dispositif de mémoire déjà existante.

Selon un aspect, il est ainsi proposé un procédé de gestion d'une opération de modification (par exemple écriture, effacement, programmation) du contenu du plan mémoire d'un dispositif de mémoire couplé à une unité de traitement.

Le procédé selon cet aspect comprend
- une communication par l'unité de traitement au dispositif de mémoire, d'une commande de ladite opération,
- une exécution de ladite opération par le dispositif de mémoire, et
- à l'issue de ladite opération, une communication par le dispositif de mémoire lui-même à ladite unité de traitement d'une information indiquant la fin de ladite opération.

Ainsi, l'unité de traitement, par exemple le microprocesseur, n'utilise pas ses ressources internes pour déterminer la fin de l'opération de modification puisque c'est le dispositif de mémoire lui-même qui va informer l'unité de traitement de la fin de cette opération.

Ainsi, on ne ralentit pas l'application et la consommation de courant n'est pas impactée.

En pratique, le dispositif de mémoire peut comporter une broche auxiliaire dont l'état logique est géré par l'unité de traitement et interprétable par le dispositif de mémoire uniquement lors de la communication de ladite commande par l'unité de traitement.

Dans ce cas, le procédé comprend avantageusement, lors de l'exécution de ladite opération et lors de la communication de ladite information de fin, une gestion de l'état logique de ladite broche auxiliaire par le dispositif de mémoire et une configuration de l'unité de traitement en mode détection d'interruption sur la broche auxiliaire.

La communication de ladite information de fin comprend alors une modification par le dispositif de mémoire de l'état logique de ladite broche auxiliaire interprétable par l'unité de traitement comme une interruption.

Ainsi, lors de la communication entre l'unité de traitement et le dispositif de mémoire pour l'émission de la commande de ladite opération, cette broche auxiliaire est dans un mode d'entrée et son état logique est géré par l'unité de traitement. Cet état logique est interprétable par le dispositif de mémoire.

Par contre, dès la fin de la commande d'opération de modification du contenu mémorise (qui marque le début de l'opération de modification proprement dite), l'état logique de cette broche auxiliaire n'est plus interprétable par le dispositif de mémoire. En conséquence, cette broche auxiliaire va passer dans une mode de sortie et être utilisée pour indiquer à l'unité de traitement la fin de l'opération d'écriture.

Plus précisément, c'est donc le dispositif de mémoire qui va gérer lui-même l'état logique de cette broche auxiliaire et modifier son état logique (créer un front descendant par exemple) une fois l'opération d'écriture (par exemple) terminée. L'unité de traitement, configurée alors en mode d'interruption, va détecter cette interruption et en conclure que l'opération d'écriture est terminée et que la mémoire est à nouveau disponible.

On voit donc ici qu'aucune ressource interne du microprocesseur n'a été utilisée, comme indiqué ci-dessus. Le microprocesseur n'a simplement qu'à gérer une interruption sur la ligne connectant la broche auxiliaire à l'unité de traitement.

Et, puisque l'on utilise une broche déjà existante du dispositif de mémoire, il n'y a aucun surcoût d'encombrement surfacique pour la solution proposée.

Selon un mode de mise en œuvre, le dispositif de mémoire est couplé à l'unité de traitement par un milieu de communication supportant un protocole de communication série.

Ce protocole de communication série comporte une ligne de signal d'horloge et au moins une ligne de signal de données ainsi qu'une ligne auxiliaire connectant ladite unité de traitement à ladite broche auxiliaire.

Et, cette ligne auxiliaire est distincte de la ligne de signal d'horloge et de ladite au moins une ligne de données.

En effet, il convient de ne pas utiliser comme ligne auxiliaire, la ligne de signal d'horloge et la ou les lignes de données car une transition sur ces lignes pourrait être interprétée comme un autre événement par l'autre unité de traitement et/ou un autre dispositif de mémoire connecté sur le milieu de communication.

Le milieu de communication peut supporter par exemple le protocole de communication I²C.

Dans ce cas, on peut choisir comme broche auxiliaire celle qui reçoit lors de la communication de ladite commande par l'unité de traitement, un signal logique auxiliaire interdisant ou autorisant l'exécution de ladite opération.

Cette broche auxiliaire peut être ainsi la broche couramment désignée par l'homme du métier sous l'acronyme /WC recevant le signal logique du même nom.

Le milieu de communication peut également être un milieu supportant le protocole de communication SPI.

Dans ce cas, la broche auxiliaire peut être celle qui reçoit lors de la communication de ladite commande par l'unité de traitement un signal logique auxiliaire causant ou non une pause dans la communication entre l'unité de traitement et le dispositif de mémoire.

En d'autres termes, cette broche auxiliaire peut être par exemple celle habituellement connue par l'homme du métier sous la dénomination « HOLD » recevant le signal logique du même nom.

En variante, toujours lorsque le protocole de communication est le protocole SPI, la broche auxiliaire peut être celle qui reçoit lors de la communication de ladite commande par l'unité de traitement, un signal logique auxiliaire activant ou désactivant une protection du dispositif de mémoire vis-à-vis de ladite opération.

En d'autres termes, dans ce cas, cette broche auxiliaire peut être celle habituellement connue par l'homme du métier sous l'acronyme WP recevant le signal logique du même nom.

Le dispositif de mémoire peut être un dispositif de mémoire non volatile, par exemple une mémoire EEPROM ou une mémoire flash.

Selon un autre aspect, il est proposé un dispositif de mémoire comprenant un plan mémoire, une interface de commande configurée pour être couplée à une unité de traitement et destinée à recevoir de la part de l'unité de traitement une commande d'une opération de modification du contenu du plan mémoire.

Le dispositif de mémoire comprend également une interface auxiliaire configurée pour être couplée à l'unité de traitement.

Le dispositif de mémoire comprend encore des moyens de traitement configurés pour exécuter ladite opération et communiquer à l'unité de traitement via l'interface auxiliaire, à l'issue de ladite opération, une information indiquant la fin de ladite opération.

Selon un mode de réalisation, l'interface auxiliaire comporte une broche auxiliaire dont l'état logique est destiné à être géré par l'unité de traitement et interprétable par les moyens de traitement uniquement lors de la communication de ladite commande par l'unité de traitement.

Par ailleurs, les moyens de traitement sont configurés pour, lors de l'exécution de ladite opération et lors de la communication de ladite information de fin, gérer l'état logique de ladite broche auxiliaire et modifier l'état logique de la broche auxiliaire de façon à générer une interruption interprétable par l'unité de traitement comme étant ladite information de fin.

Selon un mode de réalisation, l'interface de commande et l'interface auxiliaire sont configurées pour être couplées à l'unité de traitement par un milieu de communication configuré pour supporter un protocole de communication série et comportant une ligne de signal d'horloge, au moins une ligne de signal de données et une ligne auxiliaire connectant ladite unité de traitement à ladite broche auxiliaire.

Cette ligne auxiliaire est distincte de la ligne de signal d'horloge et de ladite au moins une ligne de données.

Lorsque le milieu de communication est configuré pour supporter le protocole de communication I²C, la broche auxiliaire peut être celle configurée pour recevoir lors de la communication de ladite commande par l'unité de traitement, un signal logique auxiliaire interdisant ou autorisant l'exécution de ladite opération.

Lorsque le milieu de communication est configuré pour supporter le protocole de communication SPI, la broche auxiliaire peut être celle configurée pour recevoir lors de la communication de ladite commande par l'unité de traitement, un signal logique auxiliaire causant ou non une pause dans la communication entre l'unité de traitement et le dispositif de mémoire.

En variante, toujours dans le cas d'un protocole de communication SPI, la broche auxiliaire peut être celle configurée pour recevoir lors de la communication de ladite commande par l'unité de traitement, un signal logique auxiliaire activant ou désactivant une protection du dispositif de mémoire vis-à-vis de ladite opération.

Selon un autre aspect, il est proposé un système comprenant une unité de traitement, par exemple un microprocesseur ou un microcontrôleur, le dispositif de mémoire tel que défini ci-avant, et un milieu de communication couplant l'interface de commande et l'interface auxiliaire du dispositif à ladite unité de traitement.

D'autres avantages et caractéristiques de l'invention apparaîtront à la lecture de la description détaillée ci-dessous et à l'étude des dessins annexés qui ne sont pas limitatifs, dans lesquels :
[Fig 1]
[Fig 2]
[Fig 3] et
[Fig 4] illustrent schématiquement des modes de mise en œuvre et de réalisation de l'invention,
[Fig.5] illustre un art antérieur,
[Fig 6]

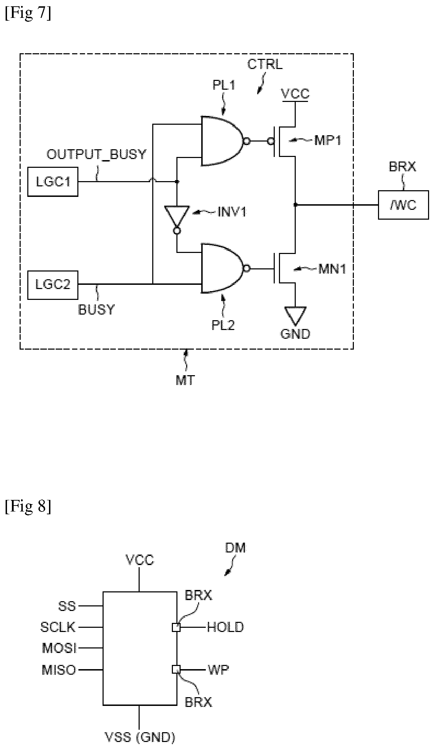

[Fig 7] et
[Fig 8] illustrent schématiquement des modes de mise en œuvre et de réalisation de l'invention,

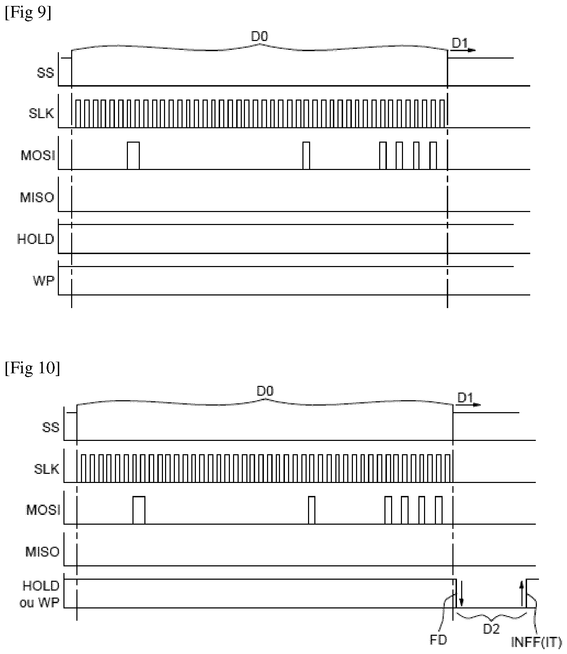

[Fig 9] illustre un autre art antérieur,
[Fig 10] et

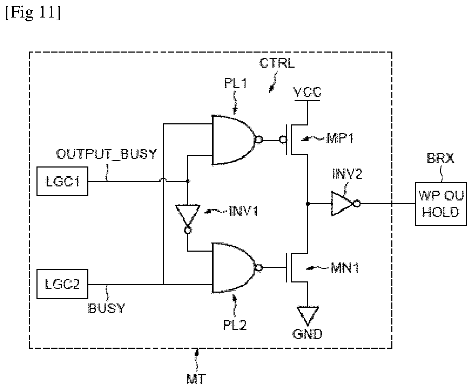

[Fig 11] illustrent schématiquement des modes de mise en œuvre et de réalisation de l'invention.

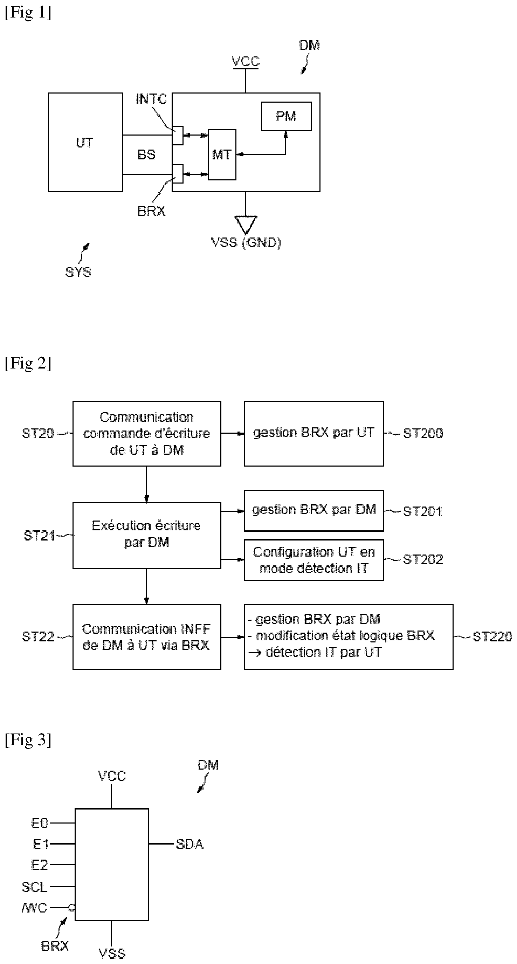

Sur la figure 1, la référence SYS désigne un système comportant une unité de traitement UT, par exemple un microprocesseur ou un microcontrôleur, connecté à un dispositif de mémoire DM par l'intermédiaire d'un milieu de communication BS, par exemple un bus.

Le dispositif de mémoire DM est ici une mémoire non volatile, par exemple une mémoire EEPROM ou une mémoire flash, sans que ces exemples ne soient limitatifs.

Le dispositif de mémoire comporte un plan mémoire PM destiné à stocker des données ainsi qu'une interface de commande INTC et une interface auxiliaire BRX.

Comme on le verra plus en détails ci-après, l'interface de commande, connectée sur le bus BS, est destinée à recevoir de la part de l'unité de traitement UT une commande d'une opération de modification du contenu du plan-mémoire, par exemple une opération d'écriture.

Des moyens de traitement MT sont connectés entre l'interface de commande INTC, l'interface auxiliaire BRX et le plan-mémoire PM et comportent des moyens classiques configurés pour exécuter ladite opération ainsi que d'autres moyens dont un exemple de structure sera décrit plus en détails ci-après, destinés à communiquer à l'unité de traitement UT via l'interface auxiliaire BRX, à l'issue de ladite opération (ici l'opération d'écriture) une information indiquant la fin de cette opération.

Enfin, le dispositif de mémoire comporte une broche connectée à une tension d'alimentation VCC et une autre broche connectée à une tension de référence VSS, par exemple la masse GND.

On verra plus en détails ci-après, que l'interface auxiliaire BRX peut être une broche du dispositif de mémoire habituellement non utilisée lorsque le dispositif de mémoire n'est plus sélectionné par l'unité de traitement.

On se réfère maintenant plus particulièrement à la figure 2 pour décrire un mode de mise en œuvre d'un procédé de gestion de l'opération de modification du contenu du plan-mémoire PM du dispositif de mémoire DM.

D'une façon générale, dans une étape ST20, l'unité de traitement communique la commande de l'opération de modification, ici la commande d'écriture, au dispositif de mémoire DM.

Dans cette phase de communication, l'interface auxiliaire BRX est gérée par l'unité de traitement UT (étape ST200).

Cette interface auxiliaire BRX est alors dans un mode d'entrée.

Une fois que la commande d'écriture a été reçue et que le dispositif de mémoire a été désélectionné sur le bus BS, le dispositif de mémoire DM exécute dans l'étape ST21 l'opération, en l'espèce l'écriture d'une donnée à une adresse définie.

Alors que dans l'étape ST200, l'état logique de l'interface auxiliaire BRX est gérée par l'unité de traitement UT et interprétable par le dispositif de mémoire, lors de l'exécution ST21 de l'écriture, l'état logique de l'interface auxiliaire BRX est géré cette fois-ci par le dispositif de mémoire (étape ST201) et l'unité de traitement UT est configurée en mode de détection d'interruption IT sur l'interface auxiliaire BRX (étape ST202).

Cette interface auxiliaire BRX est alors dans un mode de sortie.

A l'issue de l'opération d'écriture, le dispositif de mémoire DM communique (étape ST22) à l'unité de traitement via l'interface auxiliaire BRX, une information INFF indiquant la fin de l'opération d'écriture.

Dans cette phase de communication ST22, la gestion de l'état logique de la broche auxiliaire est toujours effectuée par le dispositif de mémoire (étape ST220) et la communication de l'information de fin INFF comprend une modification par le dispositif de mémoire DM de l'état logique de l'interface auxiliaire BRX, interprétable par l'unité de traitement UT comme une interruption IT. La détection de cette interruption IT par l'unité de traitement indique à celle-ci que l'opération d'écriture est terminée.

On va maintenant décrire plus en détails deux exemples particuliers de réalisation et de mise en œuvre respectivement utilisables lorsque le bus BS est un bus supportant le protocole I²C et le protocole SPI.

La figure 3 représente un dispositif intégré de mémoire non-volatile du type EEPROM, apte à communiquer sur le bus BS du type I²C.

Dans cet exemple le dispositif de mémoire comporte 3 broches d'identification matérielle E0, E1, E2, sans que ce nombre ne soit limitatif.

Les broches d'identification matérielle E0, E1, E2 sont destinées à être affectées d'un potentiel respectif définissant un code d'affectation dédié au dispositif de mémoire DM. L'affectation de ces potentiels s'effectue de façon matérielle lors de l'intégration du circuit intégré sur une carte par exemple.

Ces broches d'identification matérielle E0, E1, E2 sont couplées à VCC ou VSS. Lorsqu'elles ne sont pas connectées, ces entrées sont typiquement lues par défaut à VSS. Un couplage à VCC définit un signal logique de valeur « 1 » dans le code d'affectation, et un couplage à VSS définit un signal logique de valeur « 0 ».

Le plan-mémoire du dispositif de mémoire DM permet de stocker des données numériques dans des emplacements-mémoire arrangés en lignes et en colonnes. Un emplacement-mémoire comporte généralement un transistor à grille flottante apte à stocker physiquement une représentation d'une donnée numérique (c'est-à-dire un bit), de façon classique et connue en soi. Chaque bit est stocké dans un emplacement-mémoire et est assigné d'une adresse-mémoire respective, la communication de cette adresse permettant à la mémoire d'accéder à cet emplacement-mémoire en lecture ou en écriture.

Le dispositif intégré de mémoire DM comporte également une broche d'entrée/sortie de ligne de données série SDA et une broche d'entrée de ligne d'horloge série SCL, ainsi qu'une broche auxiliaire BRX destinée à recevoir un signal de contrôle d'écriture /WC.

La broche d'entrée/sortie de ligne de données série SDA et la broche d'entrée de ligne d'horloge série SCL font partie de l'interface de commande INTC et la broche auxiliaire BRX forme ladite interface auxiliaire.

La broche d'entrée/sortie SDA est utilisée pour transférer des données entrantes ou sortantes.

Le signal appliqué sur la broche d'entrée SCL est utilisé pour cadencer les signaux entrants et sortants sur la ligne SDA.

Le signal présent /WC sur la broche auxiliaire BRX permet de protéger le contenu de la mémoire d'opérations d'écriture accidentelles.

A titre d'exemple, les opérations d'écriture sont rendues impossibles dans la mémoire lorsque le signal /WC présent sur la broche BRX est à un niveau haut. Les opérations d'écriture sont possibles lorsque le signal /WC présent sur la broche BRX est à un niveau bas ou laissé flottant.

Le bus I²C est une norme bien connue de communication intercircuits-intégrés série.

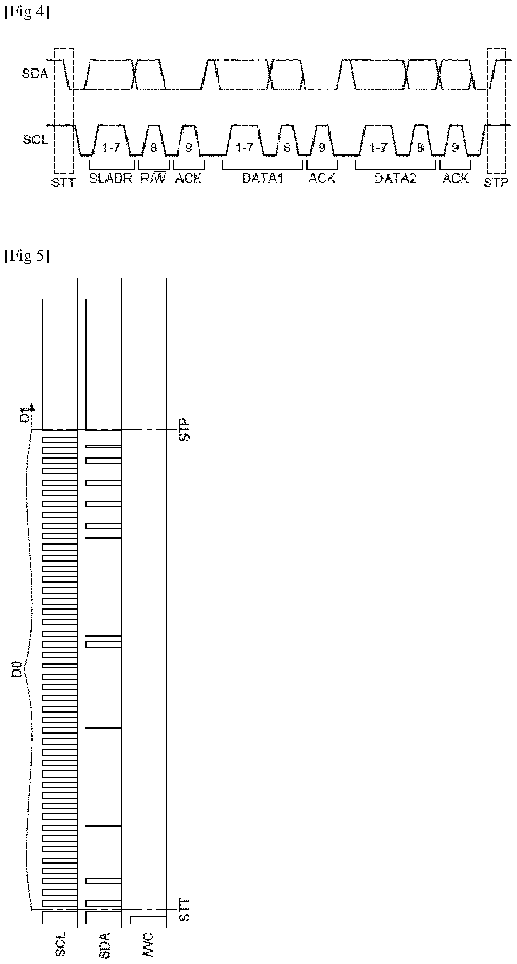

La figure 4 représente les signaux d'un exemple de communication réalisée sur un bus I²C.

Le bus I²C comporte deux fils, une ligne de données série SDA et une ligne d'horloge série SCL, qui transmettent des informations entre les appareils connectés au bus I²C. Chaque appareil est reconnu par une adresse d'esclave unique (qu'il s'agisse par exemple d'un microcontrôleur, d'une mémoire ou d'une interface clavier) et peut fonctionner comme un émetteur ou un récepteur, selon la fonction de l'appareil. Par exemple le dispositif de mémoire DM peut recevoir des données (écriture par exemple) ou transmettre des données (lecture par exemple). Un maître est le dispositif qui déclenche un transfert de données sur le bus et génère les signaux d'horloge pour permettre ce transfert. À ce moment-là, tout dispositif adressé est considéré comme un esclave.

La ligne SDA est une ligne bidirectionnelle, les données à communiquer via le bus I²C sont matérialisées par des signaux pouvant avoir un niveau HAUT ou un niveau BAS.

Pendant une transmission de données, le signal de la ligne SDA doit être stable pendant la période HAUTE du signal d'horloge. L'état HAUT ou BAS de la ligne de données SDA ne peut changer que lorsque le signal d'horloge sur la ligne SCL est BAS.

Toutes les transactions commencent par une condition de départ « START » STT et se terminent par une condition de fin « STOP » STP. Une transition HAUT vers BAS sur la ligne SDA alors que SCL est HAUT définit une condition de départ STT. Une transition BAS vers HAUT sur la ligne SDA alors que SCL est HAUT définit une condition de fin STP.

Sur la ligne SDA, les niveaux HAUT et BAS du signal représentent respectivement les valeurs logiques « 1 » et « 0 ».

Les transferts de données suivent le format représenté par la figure 1. Après la condition de départ STT, une adresse esclave SLADR est envoyée. Cette adresse est codée sur 7 bits suivis d'un huitième bit de direction R/W , un « zéro » indiquant une transmission (ou écriture) W, un « un » indiquant une demande de données (ou lecture) R.

Les données DATAI, DATA2 sont transmises par octet (soit 8 bits) sur la ligne SDA. Le nombre d'octets qui peut être transmis par transfert est illimité. Chaque octet doit être suivi d'un bit de confirmation ACK. Par convention, les données DATAI, DATA2 sont transférées avec le bit de poids fort MSB en première position.

La confirmation a lieu après chaque octet. Le bit de confirmation ACK permet au récepteur de signaler à l'émetteur que l'octet a été reçu avec succès et qu'un autre octet peut être envoyé.

Un transfert de données se termine toujours par une condition de fin STP générée par le maître.

En lecture ou en écriture, la première adresse-mémoire à accéder dans le plan-mémoire est communiquée au dispositif de mémoire immédiatement après l'adresse d'esclave SLADR.

La sélection du dispositif de mémoire sur le bus, parmi plusieurs dispositifs connectés sur ce même bus, est bien connue de l'homme du métier et dépend notamment du type et de la taille-mémoire du dispositif de mémoire.

Par exemple, dans certains cas, les trois derniers bits de poids faible de l'adresse d'esclave SLADR permettent de sélectionner un dispositif de mémoire EEPROM parmi plusieurs, par comparaison des valeurs XXX desdits bits et du code d'affectation associé à chaque dispositif de mémoire EEPROM.

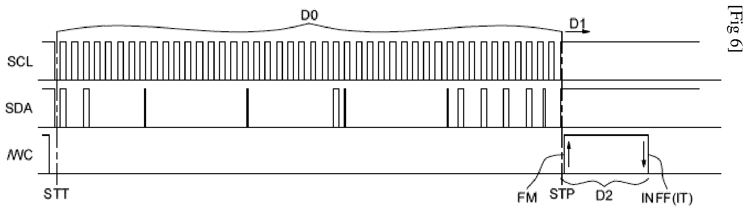

On se réfère maintenant plus particulièrement aux figures 5 et 6 qui illustrent respectivement un exemple d'écriture dans le dispositif de mémoire, selon l'art antérieur (figure 5) et selon un mode de mise en œuvre et de réalisation de l'invention (figure 6).

Comme illustré sur la figure 5, pendant la durée D0 qui s'étend entre la condition de départ STT et la condition de fin STP, l'unité de traitement UT transmet sur la ligne SDA une donnée à écrire à une adresse définie dans le plan-mémoire.

Par ailleurs, pendant cette durée D0, le signal /WC généré par l'unité de traitement et transmis sur la broche auxiliaire BRX, est à l'état bas, ce qui rend donc possible l'opération d'écriture.

A la réception de la condition de fin STP, débute une phase D1 pendant laquelle le dispositif de mémoire exécute l'opération d'écriture.

Et, pendant cette phase D1, la broche auxiliaire BRX n'est pas utilisée et son état logique n'est pas interprété par le dispositif de mémoire qui n'est, pendant cette phase D1, plus sélectionné sur le bus.

Contrairement à cet art antérieur, alors que pendant la durée D0 correspondant à l'étape ST20 de la figure 2, le signal auxiliaire /WC reste à l'état bas et est géré par l'unité de traitement UT, l'état logique de ce signal /WC est maintenant géré par le dispositif de mémoire à partir de l'occurrence de la condition de fin STP.

Plus précisément, lors de l'apparition de cette condition de fin STP, le dispositif de mémoire génère un front montant FM sur le signal auxiliaire /WC de façon à faire passer l'état logique de ce signal à l'état haut.

Puis, l'opération d'écriture s'effectue pendant la durée D2.

Et, à l'issue de cette durée D2, c'est-à-dire lorsque l'opération d'écriture est terminée, le dispositif de mémoire fait basculer à nouveau l'état logique du signal auxiliaire /WC à l'état bas.

Il y a donc génération d'un front descendant, ce qui est interprété par l'unité de traitement comme une interruption IT signifiant la fin de l'opération d'écriture et correspondant à l'information de fin INFF.

Il convient de noter ici que le front montant FM du signal /WC n'a pas été interprété par l'unité de traitement comme étant une interruption car celle-ci a été configurée pour détecter en tant qu'interruption, les fronts descendants du signal /WC.

D'un point de vue matériel, l'exemple de circuit, très schématique, illustré sur la figure 7, permet la gestion de l'état logique du signal délivré sur la borne auxiliaire BRX par les moyens de traitement du dispositif de mémoire lors de la durée D2.

A cet égard, les moyens de traitement MT comportent un module de contrôle CTRL comportant un transistor PMOS MP1 dont la source est reliée à la tension VCC et dont le drain est relié à la borne auxiliaire BRX, ainsi qu'un transistor NMOS MN1 dont la source est reliée à la masse GND et dont le drain est relié également à la broche auxiliaire BRX.

La grille du transistor MP1 est reliée à la sortie d'une porte logique NON ET, référencée PL1, et la grille du transistor MN1 est reliée à la sortie d'une porte logique NON OU référencée PL2.

Une première entrée de la porte logique PL1 et une première entrée de la porte logique PL2 reçoivent un bit référencé BUSY.

La deuxième entrée de la porte logique PL1 reçoit un bit référencé OUTPUT_BUSY et la deuxième entrée de la porte logique PL2 reçoit le bit OUTPUT_BUSY inversé par l'intermédiaire d'un inverseur INV1.

Le bit OUTPUT_BUSY est délivré par une logique de commande LGC1 tandis que le bit BUSY est délivré par une logique de commande LGC2.

Le bit OUTPUT_BUSY est représentatif de l'état « mode d'entrée » ou « mode de sortie » de la broche auxiliaire BRX, c'est-à-dire de l'équipement qui gère son état logique (l'unité de traitement en mode entrée ou le dispositif de mémoire en mode sortie).

Ainsi, par exemple, le bit OUTPUT_BUSY a la valeur logique 0 pendant l'étape ST20 (durée D0) et il prend l'état logique 1 lors de l'apparition de la condition de fin STP.

La valeur de ce bit est gérée en fonction de la commande envoyée à la mémoire (signal « write ») et de la condition de fin de communication (correspondant à la désélection du dispositif de mémoire sur le bus) par l'unité de traitement. L'homme du métier saura réaliser la logique de commande LGC1 en conséquence.

Quant au bit BUSY, c'est un bit habituellement délivré par la mémoire pour signifier qu'elle est ou non disponible. En d'autres termes, tant que l'opération d'écriture n'a pas commencé, le bit BUSY est à 0. Puis il passe à 1 pendant l'opération d'écriture et repasse à 0 à la fin de l'opération d'écriture.

La logique LGC2 est une logique de structure classique.

On voit donc sur la figure 7 que lorsque le bit OUTPUT_BUSY est à 0, un état haut est appliqué sur la grille du transistor MP1 le rendant bloqué. De même, un état 0 est appliqué sur la grille du transistor MN1 le rendant bloqué. Par conséquent, les transistors MP1 et MN1 sont déconnectés de la broche auxiliaire BRX ce qui permet à l'unité de traitement de gérer l'état logique de cette broche auxiliaire.

Par contre, lorsqu'à l'apparition de la condition de fin STP, le bit OUTPUT_BUSY passe à 1 de même que le bit BUSY, le transistor MP1 devient passant tandis que le transistor MN1 est bloqué. Par conséquent, le signal auxiliaire /WC passe à l'état haut.

Il reste à l'état haut tant que l'opération d'écriture n'est pas terminée. Et, une fois que l'opération d'écriture est terminée, le bit BUSY passe à 0 ce qui bloque le transistor MP1 et rend passant le transistor MN1. Par conséquent, le signal auxiliaire /WC passe à l'état 0 ce qui provoque la transition descendante détectée par l'unité de traitement comme une interruption et interprétée comme étant l'information INFF de fin d'écriture.

Dans le mode de réalisation de la figure 8, le dispositif de mémoire est connecté à l'unité de traitement par un bus supportant le protocole SPI.

Le protocole SPI est bien connu de l'homme de l'art.

On rappelle ci-après certaines caractéristiques.

Le maître est relié à un ou plusieurs esclaves via 4 lignes (dans un mode de transmission bidirectionnelle simultanée) ou plus :
SCLK : horloge
MOSI : sortie maître, entrée esclave, pour transmettre des données à un esclave
MISO : entrée maître, sortie esclave, pour recevoir des données d'un esclave
SS : ligne de sélection d'esclave (active niveau bas pour sélectionner l'esclave).

En conséquence le dispositif de mémoire comporte quatre broches protocolaires respectivement connectées sur les lignes SS, MISO, MOSI et SCLK. Ces broches protocolaires font partie de l'interface de commande.

Le dispositif de mémoire DM comporte également deux broches auxiliaires BRX respectivement destinées à recevoir de la part de l'unité de traitement UT un signal auxiliaire WP et un signal auxiliaire HOLD.

Le signal auxiliaire WP est un signal activant ou désactivant une protection du dispositif de mémoire vis-à-vis de l'opération d'écriture.

Lorsque le signal WP est à l'état haut, une écriture est possible.

Lorsque le signal WP est à l'état bas, une écriture n'est pas possible.

Le signal HOLD est un signal logique auxiliaire causant ou non une pause dans la communication entre l'unité de traitement et le dispositif de mémoire.

Lorsque le signal HOLD est à l'état bas, la communication est suspendue alors qu'elle ne l'est pas si le signal HOLD est à l'état haut.

Comme on le verra plus en détails ci-après, on peut choisir comme interface auxiliaire l'une de ces deux broches auxiliaires.

Le système SPI peut être configuré pour fonctionner avec un seul maître et un seul esclave, et il peut être configuré avec plusieurs esclaves commandés par un seul maître. Il y a deux façons de relier plusieurs esclaves au maître. Si le maître a plusieurs broches de sélection d'esclave, les esclaves peuvent être câblés en parallèle. Si une seule broche de sélection d'esclave est disponible, les esclaves peuvent être reliés en cascade.

Le signal d'horloge SCLK synchronise la sortie de bits de données du maître à l'échantillonnage de bits par l'esclave. Un bit de donnée est transféré à chaque cycle d'horloge, de sorte que la vitesse de transfert des données est déterminée par la fréquence du signal d'horloge. La communication SPI est toujours déclenchée par le maître puisque le maître configure et génère le signal d'horloge.

Le maître peut choisir avec quel esclave il veut dialoguer en mettant la ligne SS de l'esclave à un niveau de tension bas. Dans l'état inactif, sans transmission, la ligne de sélection d'esclave est maintenue à un niveau de tension haut.

Le maître envoie des données à l'esclave bit par bit, en série via la ligne MOSI. L'esclave reçoit les données envoyées par le maître sur la broche MOSI. Les données envoyées du maître à l'esclave sont généralement, mais pas obligatoirement, envoyées avec le bit de poids fort (MSB) en premier.

L'esclave peut aussi envoyer en retour des données au maître via la ligne MISO en série. Les données envoyées de l'esclave au maître sont généralement envoyées avec le bit de poids faible (LSB) en premier.

Les données ne sont valides que pendant le niveau bas de SS.

Les étapes de la transmission de données SPI sont les suivantes :
Le maître délivre le signal d'horloge ; le maître fait passer la broche SS à un état de tension bas, ce qui active l'esclave ; le maître envoie les données bit par bit à l'esclave sur la ligne MOSI. L'esclave lit les bits à mesure qu'il les reçoit ; si une réponse est nécessaire, l'esclave renvoie des données bit par bit au maître sur la ligne MISO. Le maître lit les bits à mesure qu'il les reçoit.

Lors d'une opération d'écriture, l'unité de traitement est le maître sur le bus et le dispositif mémoire est l'esclave.

La figure 9 illustre une opération d'écriture dans le dispositif de mémoire DM selon l'art antérieur.

Au cours de la phase D0 de sélection du dispositif de mémoire sur le bus SPI, le signal de sélection SS est à l'état bas et la commande de l'écriture contenant la donnée à écrire ainsi que l'adresse où cette donnée doit être écrite, est communiquée sur la ligne MOSI.

Lorsque le produit est désélectionné (signal SS à l'état haut) débute la phase D1 au cours de laquelle l'écriture proprement dite est effectuée.

On voit que pendant que la phase D0, les signaux auxiliaires HOLD et WP sont ici à l'état haut ce qui signifie que la communication n'est pas interrompue et qu'il est possible d'écrire dans la mémoire.

Et, pendant la durée D1, ces signaux restent à l'état haut et de toute façon ne sont pas interprétables par le dispositif de mémoire.

Par contre, dans un mode de mise en œuvre de l'invention illustré sur la figure 10, lorsque le dispositif de mémoire est désélectionné à l'issue de la phase D0 (signal SS à l'état haut) le signal auxiliaire HOLD ou bien le signal auxiliaire WP (selon le choix qui a été fait) redescend à l'état bas sous l'action des moyens de traitement du dispositif de mémoire générant de ce fait un front descendant FD.

Ce signal auxiliaire reste à l'état bas pendant toute la durée D2 de l'opération d'écriture proprement dite.

Et, lorsque cette opération d'écriture est terminée, les moyens de traitement MT du dispositif de mémoire font remonter le signal auxiliaire à l'état haut, générant une interruption IT interprétée par l'unité de traitement comme étant l'information INFF de fin de l'opération d'écriture.

Il convient de noter ici que, dans le cas du bus SPI, l'unité de traitement est configurée pour être en mode de détection d'interruption sur front montant.

Un exemple de moyens matériels permettant la gestion du signal auxiliaire HOLD ou WP par les moyens de traitement au cours de la durée D2 est représenté sur la figure 11.

On voit ici que la structure de ces moyens de traitement est analogue à celle qui a été décrite en référence à la figure 7 à la différence près qu'il est prévu maintenant un inverseur INV2 connecté entre les drains des transistors MP1 et MN1 et la broche auxiliaire BRX choisie.

Le fonctionnement de ces moyens est donc analogue à ce qui a été décrit ci-après, l'inversion du signal logique délivré sur la borne BRX étant produite par l'inverseur INV2.

Par ailleurs, la structure interne de la logique LGC1 est adaptée aux signaux du bus SPI.

## Revendications

1. Procédé de gestion d'une opération de modification du contenu du plan mémoire d'un dispositif de mémoire couplé à une unité de traitement, comprenant une communication (ST20) par l'unité de traitement (UT) au dispositif de mémoire (DM) d'une commande de ladite opération, une exécution (ST21) de ladite opération par le dispositif de mémoire, et à l'issue de ladite opération, une communication (ST22) par le dispositif mémoire lui-même à ladite unité de traitement d'une information (INFF) indiquant la fin de ladite opération.

2. Procédé selon la revendication 1, dans lequel le dispositif comporte une broche auxiliaire (BRX) dont l'état logique est géré par l'unité de traitement et interprétable par le dispositif de mémoire uniquement lors de la communication de ladite commande par l'unité de traitement, le procédé comprenant, lors de l'exécution de ladite opération et lors de la communication de ladite information de fin, une gestion de l'état logique de ladite broche auxiliaire (BRX) par le dispositif de mémoire et une configuration de l'unité de traitement en mode détection d'interruption sur ladite broche auxiliaire, et la communication de ladite information de fin comprend une modification par le dispositif de mémoire de l'état logique de ladite broche auxiliaire (BRX) interprétable par l'unité de traitement comme une interruption (IT).

3. Procédé selon la revendication 2, dans lequel le dispositif de mémoire est couplé à l'unité de traitement par un milieu de communication (BS) supportant un protocole de communication série et comportant une ligne de signal d'horloge, au moins une ligne de signal de données, et une ligne auxiliaire connectant ladite unité de traitement à ladite broche auxiliaire, la ligne auxiliaire étant distincte de la ligne de signal d'horloge et de ladite au moins une ligne de données.

4. Procédé selon la revendication 3, dans lequel le milieu de communication (BS) supporte le protocole de communication I²C, et la broche auxiliaire (BRX) reçoit lors de la communication de ladite commande par l'unité de traitement, un signal logique auxiliaire (/WC) interdisant ou autorisant l'exécution de ladite opération.

5. Procédé selon la revendication 3, dans lequel le milieu de communication supporte le protocole de communication SPI, et la broche auxiliaire (BRX) reçoit lors de la communication de ladite commande par l'unité de traitement, un signal logique auxiliaire (HOLD) causant ou non une pause dans la communication entre l'unité de traitement et le dispositif de mémoire.

6. Procédé selon la revendication 3, dans lequel le milieu de communication supporte le protocole de communication SPI, et la broche auxiliaire (BRX) reçoit lors de la communication de ladite commande par l'unité de traitement, un signal logique auxiliaire (WP) activant ou désactivant une protection du dispositif de mémoire vis-à-vis de ladite opération.

7. Procédé selon l'une des revendications précédentes, dans lequel le dispositif de mémoire (DM) est un dispositif de mémoire non volatile.

8. Dispositif de mémoire, comprenant un plan-mémoire, une interface de commande (INTC) configurée pour être couplée à une unité de traitement (UT) et destinée à recevoir de la part de l'unité de traitement une commande d'une opération de modification du contenu du plan-mémoire, une interface auxiliaire (BRX) configurée pour être couplée à l'unité de traitement, et des moyens de traitement (MT) configurés pour exécuter ladite opération et communiquer à l'unité de traitement via l'interface auxiliaire, à l'issue de ladite opération, une information indiquant la fin de ladite opération.

9. Dispositif selon la revendication 8, dans lequel l'interface auxiliaire comporte une broche auxiliaire (BRX) dont l'état logique est destiné à être géré par l'unité de traitement et interprétable par les moyens de traitement uniquement lors de la communication de ladite commande par l'unité de traitement, et les moyens de traitement sont configurés pour, lors de l'exécution de ladite opération et lors de la communication de ladite information de fin, gérer l'état logique de ladite broche auxiliaire et modifier l'état logique de la broche auxiliaire de façon à générer une interruption interprétable par l'unité de traitement comme étant ladite information de fin.

10. Dispositif selon la revendication 9, dans lequel l'interface de commande (INTC) et l'interface auxiliaire (BRX) sont configurées pour être couplées à l'unité de traitement par un milieu de communication configuré pour supporter un protocole de communication série et comportant une ligne de signal d'horloge, au moins une ligne de signal de données, et une ligne auxiliaire connectant ladite unité de traitement à ladite broche auxiliaire, la ligne auxiliaire étant distincte de la ligne de signal d'horloge et de ladite au moins une ligne de données.

11. Dispositif selon la revendication 10, dans lequel le milieu de communication est configuré pour supporter le protocole de communication I²C, et la broche auxiliaire (BRX) est configurée pour recevoir lors de la communication de ladite commande par l'unité de traitement, un signal logique auxiliaire (/WC) interdisant ou autorisant l'exécution de ladite opération.

12. Dispositif selon la revendication 10, dans lequel le milieu de communication est configuré pour supporter le protocole de communication SPI, et la broche auxiliaire (BRX) est configurée pour recevoir lors de la communication de ladite commande par l'unité de traitement, un signal logique auxiliaire (HOLD) causant ou non une pause dans la communication entre l'unité de traitement et le dispositif de mémoire.

13. Dispositif la revendication 10, dans lequel le milieu de communication est configurée pour supporter le protocole de communication SPI, et la broche auxiliaire (BRX) est configurée pour recevoir lors de la communication de ladite commande par l'unité de traitement, un signal logique auxiliaire (WP) activant ou désactivant une protection du dispositif de mémoire vis-à-vis de ladite opération.

14. Dispositif selon l'une des revendications 8 à 13, dans lequel le dispositif de mémoire (DM) est un dispositif de mémoire non volatile.

15. Système comprenant une unité de traitement (UT), le dispositif de mémoire (DM) selon l'une des revendications 8 à 14, et un milieu de communication (BS) couplant l'interface de commande et l'interface auxiliaire du dispositif à ladite unité de traitement.
